(19) Europäisches Patentamt
European Patent Office
Office européen des brevets

(11) EP 3 647 939 A1

(12) EUROPEAN PATENT APPLICATION

(43) Date of publication:
06.05.2020 Bulletin 2020/19

(51) Int Cl.:
G06F 7/483 (2006.01)          G06F 9/30 (2018.01)

(21) Application number: 19200007.3

(22) Date of filing: 27.09.2019

(84) Designated Contracting States:
AL AT BE BG CH CY CZ DE DK EE ES FI FR GB
GR HR HU IE IS IT LI LT LU LV MC MK MT NL NO
PL PT RO RS SE SI SK SM TR
Designated Extension States:
BA ME
Designated Validation States:
KH MA MD TN

(30) Priority: 31.10.2018   JP 2018204893

(71) Applicant: FUJITSU LIMITED
Kanagawa 211-8588 (JP)

(72) Inventors:
• YOSHINAGA, Tooru
  Kawasaki-shi,, Kanagawa 211-8588 (JP)
• WADA, Hiroyuki
  Kawasaki-shi,, Kanagawa 211-8588 (JP)

(74) Representative: Haseltine Lake Kempner LLP
Lincoln House, 5th Floor
300 High Holborn
London WC1V 7JH (GB)

(54) **ARITHMETIC PROCESSING APPARATUS AND CONTROLLING METHOD THEREFOR**

(57) An arithmetic processing apparatus includes a selection circuit and an arithmetic circuit. The selection circuit outputs a specific bit of a fixed-point number when an instruction signal for converting a floating-point number to a fixed-point number is input, and outputs an exponent of the floating-point number when the instruction signal is not input; and the arithmetic circuit performs a predetermined arithmetic operation on the specific bit or the exponent output from the selection circuit.

FIG. 10

**Description**

FIELD

The embodiment discussed herein is related to an arithmetic processing apparatus and a controlling method therefor.

BACKGROUND

Numerical values handled in computers are roughly classified into two types. One is a floating-point number and the other is a fixed-point number. Japanese Laid-open Patent Publication No. 5-173759 and Japanese Laid-open Patent Publication No. 2009-93662 are examples of the related art.

When a floating-point multiply-and-add unit is used to execute an instruction for conversion to a fixed-point number, the bit width of the significand of a fixed-point number is larger than that of a floating-point number and therefore an adder capable of calculating a larger number of digits than the number of digits used for calculating a carry generated by a rounding operation is used.

This might lead to addition of a dedicated or additional adder to the floating-point multiply-and-add unit, increasing the circuit area.

In addition, operation results in accordance with the respective formats of the floating-point number and the fixed-point number are output. This might lead to addition of a circuit for format conversion in a floating-point multiply-and-add unit, increasing the circuit area.

An aspect of the embodiment is to enable arithmetic operations of a fixed-point number and a floating-point number to be performed with fewer circuit components.

SUMMARY

According to an aspect of the embodiments, an arithmetic processing apparatus including: a selection circuit that outputs a specific bit of a fixed-point number when an instruction signal for converting a floating-point number to a fixed-point number is input, and outputs an exponent of the floating-point number when the instruction signal is not input; and a first arithmetic circuit that performs a predetermined arithmetic operation on the specific bit or the exponent output from the selection circuit.

BRIEF DESCRIPTION OF DRAWINGS

FIG. 1 is a diagram illustrating a format of a single-precision floating-point number;
FIG. 2 is a diagram illustrating a format of a fixed-point number;

FIG. 3 is a diagram illustrating conversion from a floating-point number to a fixed-point number in a related example;
FIG. 4 is a diagram illustrating a round-to-nearest mode in the related example;
FIG. 5 is a table illustrating the round-to-nearest mode in the related example;
FIG. 6 is a sequence diagram illustrating an arithmetic process in a floating-point multiply-and-add unit as the related example;
FIG. 7 is a sequence diagram illustrating the arithmetic process in the floating-point multiply-and-add unit as the related example;
FIG. 8 is a diagram illustrating circuitry that performs rounding during a floating-point operation in the related example;
FIG. 9 is a diagram illustrating circuitry that performs rounding during floating-point to fixed-point conversion in the related example;
FIG. 10 is a block diagram illustrating an example of a hardware configuration of an arithmetic processing system according to an embodiment;
FIG. 11 is a diagram illustrating circuitry that performs rounding during floating-point to fixed-point conversion in a floating-point multiply-and-add unit illustrated in FIG. 10;
FIG. 12 is a block diagram illustrating a configuration of the floating-point multiply-and-add unit illustrated in FIG. 10;
FIG. 13 is a block diagram illustrating the configuration of the floating-point multiply-and-add unit illustrated in FIG. 10; and
FIG. 14 is a flowchart illustrating a floating-point exponent calculation process in the floating-point multiply-and-add unit illustrated in FIG. 10.

DESCRIPTION OF EMBODIMENTS

Hereinafter, an embodiment will be described with reference to the accompanying drawings. However, the embodiment described below is merely exemplary and is in no way intended to exclude various modifications and technical applications that are not explicitly described in the embodiment. That is, the present embodiment may be carried out with various modifications without departing from the spirit and scope thereof.

The drawings are not intended to include only the components illustrated therein but may include other functions and so on.

Hereinafter, in the drawings, like portions are denoted by the same reference numerals and redundant description thereof is omitted.

[A] Related Example

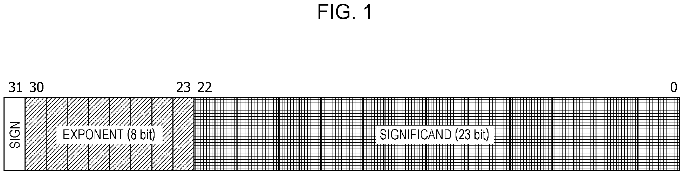

FIG. 1 is a diagram illustrating a format of a single-precision floating-point number.

A 32-bit single-precision floating-point number illustrated in FIG. 1 consists of the sign, the significand, and the exponent. The sign is 1 bit wide, where 0 represents the positive sign and 1 represents the negative sign. The significand is 23 bits wide and represents a binary fraction part with an integer part of 1. The integer part of 1 is not expressed. The exponent is 8 bits wide and may be represented as an unsigned binary number that is biased by 127.

The single-precision floating-point number illustrated in FIG. 1 is represented as the following formula.

$$(-1)^{sign} \times 2^{exponent-127} \times (1+significand)$$

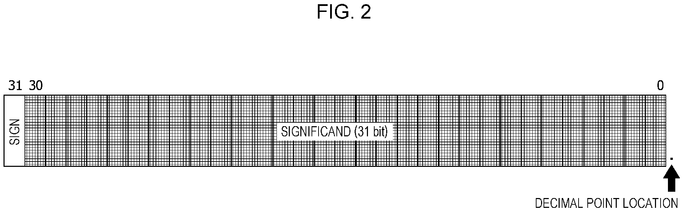

FIG. 2 is a diagram illustrating a format of a fixed-point number. A fixed-point number is a number represented such that the place of the decimal point is fixed. The number of bits of the integer part and the number of bits of the fraction part are represented in Q format.

For the decimal point location illustrated in FIG. 2, the number of bits of the integer part is 31 and the number of bits of the fraction part is 0, and therefore these numbers are represented in Q31.0 format.

There are numerical value conversion instructions for interchangeably using a floating-point number and a fixed-point number.

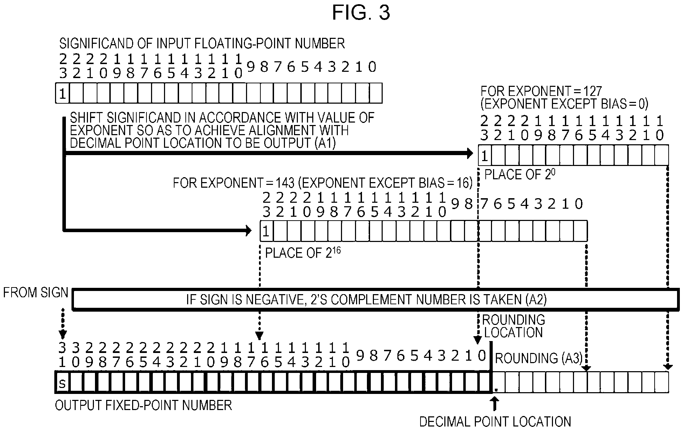

FIG. 3 is a diagram illustrating conversion from a floating-point number to a fixed-point number in the related example.

The significand (including an implicit bit "1") of a floating-point number is shifted in accordance with an amount indicated by the exponent so as to achieve alignment with the decimal point location of a fixed-point number to be output (see reference character A1).

For example, in the case of the exponent=127 (the exponent except the bias is 0), the decimal point location is at the 23rd bit, which is the place of $2^0$. In the case of exponent=143 (the exponent except the bias is 16), the decimal point location is at the 7th bit, which is the place of $2^{16}$.

If the sign of the floating-point number is negative, the shifted significand is 2's complemented (see reference character A2). If the sign is positive, the value of the significand is left intact.

Then, a rounding process is performed (see reference character A3).

As a result of shifting denoted by reference character A1, in some cases, an operation result has digits that are out of the range of possible digits in the fixed-point representation. Therefore, to maintain the operation precision, the rounding process denoted by reference character A3 is performed.

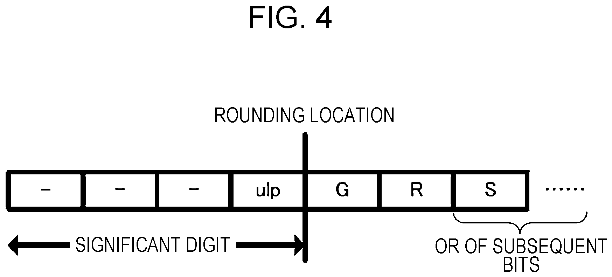

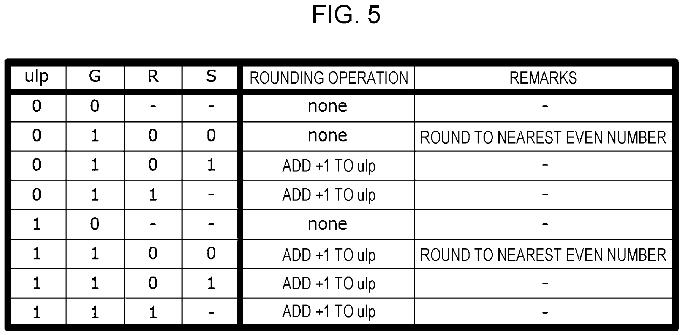

FIG. 4 is a diagram illustrating a round-to-nearest mode in the related example. FIG. 5 is a table illustrating the round-to-nearest mode in the related example.

As illustrated in FIG. 4, in performing rounding in a round-to-nearest mode, the least significant bit is referred to as the unit in the last place (ulp), and the guard bit (G), the round bit (R), and the sticky bit (S), which determine the size of lower-order bits than ulp, are defined.

The guard bit is a bit with a weight of 1/2 ulp. The round bit is a bit with a weight of 1/4 ulp. The sticky bit has a value that is the OR of bits with smaller weights than the round bit.

Rounding operations with the value of each bit of ulp/G/R/S is performed by adding +1 to ulp in the case of conditions illustrated in FIG. 5.

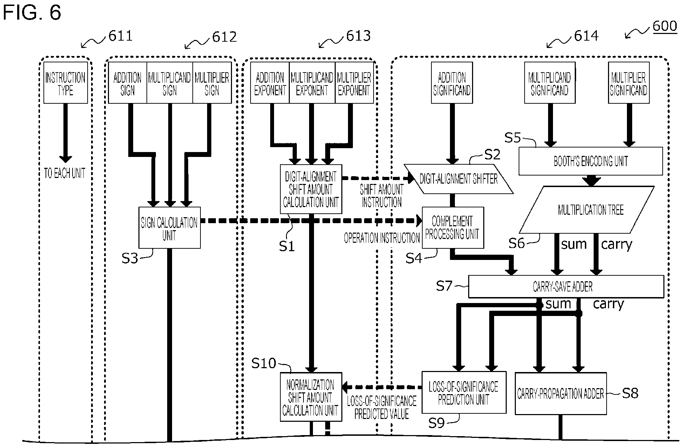

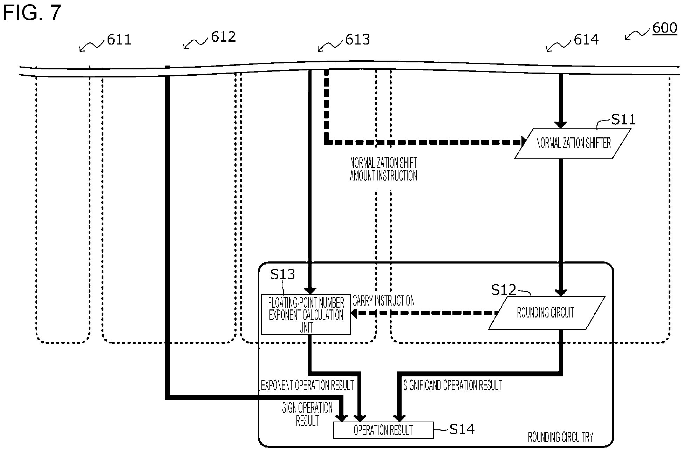

FIG. 6 and FIG. 7 are sequence diagrams illustrating an arithmetic process in the floating-point multiply-and-add unit 600 as the related example.

In the example illustrated in FIG. 6, a floating-point to fixed-point conversion instruction is executed by a floating-point multiply-and-add unit 600. The floating-point multiply-and-add unit 600 includes functions of an operation instruction control unit 611, a sign processing unit 612, an exponent processing unit 613, and a significand processing unit 614.

As illustrated in FIG. 6, the operation instruction control unit 611 notifies the sign processing unit 612, the exponent processing unit 613, and the significand processing unit 614 of an instruction type.

The exponent processing unit 613 calculates the amount of bits to be shifted, at a digit-alignment shift amount calculation unit based on an addition exponent, a multiplicand exponent, and a multiplier exponent, and instructs the significand processing unit 614 to perform a shift by the calculated shift amount (step S1).

The significand processing unit 614 performs a shift to achieve digit alignment, at a digit-alignment shifter, based on the instruction on the shift amount from the exponent processing unit 613 (step S2).

The sign processing unit 612 performs a sign calculation at a sign calculation unit based on an addition sign, a multiplicand sign, and a multiplier sign and issues an operation instruction to the significand processing unit 614

(step S3). As illustrated in FIG. 7, based on the sign calculation, a sign operation result is output.

The significand processing unit 614 performs a complement process at a complement processing unit based on the operation instruction from the sign processing unit 612 (step S4). The process then proceeds to step S7.

The significand processing unit 614 performs encoding according to the Booth's multiplication algorithm at a Booth's encoding unit based on a multiplicand significand and a multiplier significand (step S5).

The significand processing unit 614 outputs a sum signal and a carry signal from a multiplication tree (step S6).

The significand processing unit 614 outputs a sum signal and a carry signal from a carry-save adder (step S7).

The significand processing unit 614 sequentially sends carry information to the next bit calculation from a carry-propagation adder based on the sum signal and the carry signal from the carry-save adder (step S8). The process then proceeds to step S11 in FIG. 7.

The significand processing unit 614 calculates a loss-of-significance predicted value at a loss-of-significance prediction unit based on the sum signal and the carry signal from the carry-save adder and notifies the exponent processing unit 613 of the calculated loss-of-significance predicted value (step S9).

The exponent processing unit 613 calculates a normalization shift amount at a normalization shift amount calculation unit based on the loss-of-significance predicted value from the significand processing unit 614 (step S10). As illustrated in FIG. 7, the calculated normalization shift amount is provided as a normalization shift amount instruction to the significand processing unit 614.

In FIG. 7, the significand processing unit 614 performs a shift process at a normalization shifter based on the normalization shift amount instruction from the exponent processing unit 613 (step S11).

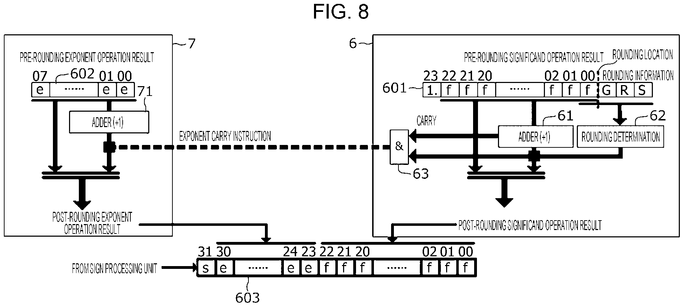

The significand processing unit 614 performs a rounding process at a rounding circuit 6 (refer to FIG. 8) based on an output from the normalization shifter and outputs a significand operation result, and also issues a carry instruction to the exponent processing unit 613 (step S12).

The exponent processing unit 613 outputs an exponent operation result at a floating-point number exponent calculation unit based on the output from the normalization shift amount calculation unit and the carry instruction from the significand processing unit 614 (step S13).

An operation result of a fixed-point number is output based on the sign operation result, the exponent operation result, and the significand operation result (step S14).

FIG. 8 is a diagram illustrating circuitry that performs rounding during a floating-point operation in the related example.

Data of the significand in which the significand, a portion of which has been lost by the normalization shifter, is shifted left and an implicit bit "1" is included is input as a pre-rounding significand operation result 601 to the rounding circuit 6. At this point, G/R/S to be used for rounding (in other words, the value of 1 bit into which the ORs of the subsequent bits are collected) is also input.

Simultaneously with a rounding determination 62 by using ulp/G/R/S, bits 22 to 0 (namely, ulp bits) of the significand are input to an adder 61.

As a result of the rounding determination 62, if a rounding operation is required, the output of the adder 61 is provided as a post-rounding significand operation result, whereas if a rounding operation is not required, bits 22 to 0 are output as is.

Simultaneously with this, if bits 22 to 0 are all "1", a carry signal is output from the adder 61. At this point, if a rounding operation is required, in order to provide a notification that carrying in the exponent is required as a result of rounding, an exponent carry instruction is output to a floating-point exponent calculation unit 7 via an OR operation circuit 63.

In the floating-point exponent calculation unit 7, an exponent value corrected with the loss-of-significance predicted value is received as a pre-rounding exponent operation result 602. If an exponent carry instruction is issued by the rounding circuit 6, the corrected exponent together with +1 added by an adder 71 is output, whereas if no exponent carry instruction is issued, the corrected exponent is output as is.

The significand operation result from the rounding circuit 6, the exponent operation result from the floating-point exponent calculation unit 7, and the sign from the sign processing unit 612 are collected together and are output as an operation result 603.

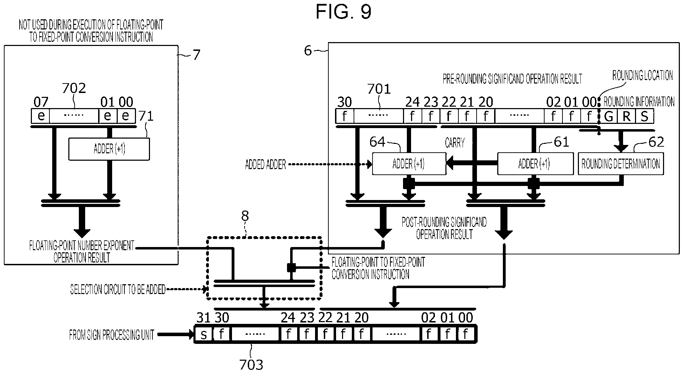

FIG. 9 is a diagram illustrating circuitry that performs rounding during floating-point to fixed-point conversion in the related example.

Bits 30 to 0 of a pre-rounding significand operation result 701 after the shift process and the complement process and G/R/S to be used for rounding are input to the rounding circuit 6. In this case, floating-point rounding, in which the number of bits to be input increases, requires a larger adder.

In the example illustrated in FIG. 9, to reduce the amount of resources as much as possible, an adder 64 to which additional bits 30 to 23 are input is added. The adder 64 performs an addition operation when the adder 61 outputs a carry signal.

As a result of the rounding determination 62, if a rounding operation is required, the outputs of the adder 61 and the added adder 64 are provided as a post-rounding significand operation result, whereas if a rounding operation is not required, bits 30 to 0 are output as is.

In outputting an operation result, in the case of a floating-point to fixed-point conversion instruction, bits 30 to 23 of a post-rounding integer operation result are output instead of a floating-point exponent operation result. For bits 22 to 0, a post-rounding significand operation result is output as is, as in the case of a floating-point operation.

A selection circuit 8 outputs at least one of inputs from the rounding circuit 6 and the floating-point exponent calculation unit 7. In the case of a floating-point to fixed-point conversion instruction, the selection circuit 8 outputs only an input from the rounding circuit 6. Thus, an operation result 703 is output.

When a floating-point multiply-and-add unit is used to execute an instruction for conversion to a fixed-point number, the bit width of the significand of a fixed-point number is larger than that of a floating-point number and therefore an adder capable of calculating a larger number of digits than the number of digits used for calculating a carry generated by a rounding operation is used.

This leads to addition of a dedicated or additional adder to a floating-point multiply-and-add unit, increasing the circuit area.

In outputting operation results, the operation results in accordance with the respective formats of the floating-point number and the fixed-point number are output. This leads to addition of a circuit for format conversion in a floating-point multiply-and-add unit, increasing the circuit area.

In the circuitry that performs rounding during floating-point to fixed-point conversion illustrated in FIG. 9, attention is paid to the adder 71 of the floating-point exponent calculation unit 7 that is not used during the floating-point to fixed-point conversion.

The adder 71 of the floating-point exponent calculation unit 7 and the adder 64 added for a floating-point to fixed-point conversion instruction in the rounding circuit 6 each have a width of 8 bits.

The adder 71 of the floating-point exponent calculation unit 7 is not used during execution of a floating-point to fixed-point conversion instruction.

Further, a carry signal is coupled from the adder 61 of the rounding circuit 6 to the floating-point exponent calculation unit 7. Accordingly, if a change may be made so that the adder 71 of the floating-point exponent calculation unit 7 is used during execution of a floating-point to fixed-point conversion instruction, addition of carrying by a rounding operation may be performed without adding an additional adder.

[B] Example of Embodiment

[B-1] Example of System Configuration

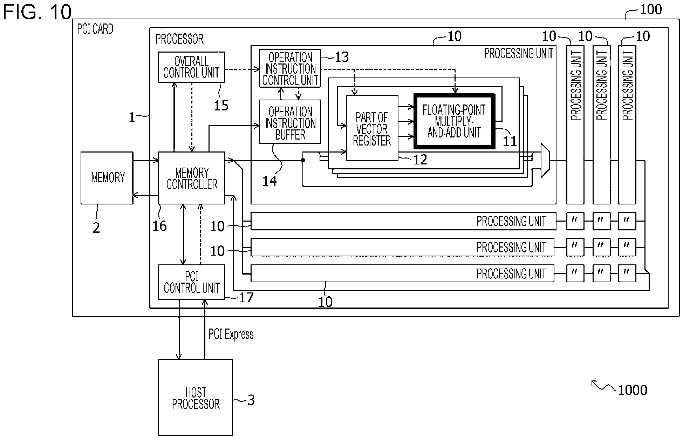

FIG. 10 is a block diagram illustrating an example of a hardware configuration of an arithmetic processing system 1000 according to an embodiment.

Recently, deep learning technologies have become commercially practical in various fields, and there are processors, as exemplified by a graphics processing unit (GPU), on which a large number of processors are mounted. In deep learning, processors capable of processing a large amount of multiply-and-add operations are used for convolutions and the like.

The arithmetic processing system 1000 includes a peripheral component interconnect (PCI) card 100 and a host processor 3.

The host processor 3 issues various instructions to the PCI card 100 via PCI Express.

The PCI card 100 includes the processor 1 and a memory 2.

The memory 2 is exemplarily a storage including a read-only memory (ROM) and a random-access memory (RAM).

On the processor 1 mounted on the PCI card 100, like a GPU, a large number of processing units 10 with floating-point multiply-and-add units mounted thereon are coupled in a matrix and are mounted in order to process a large amount of multiply-and-add operations. The processor 1 includes a plurality of processing units 10, an overall instruction control unit 15, a memory controller 16, and a PCI control unit 17.

In FIG. 10, among a plurality of processing units, only some of the processing units are denoted by reference numeral "10" and the other processing units are not denoted.

The overall instruction control unit 15 controls operations of the entirety of the processor 1.

The memory controller 16 controls input and output between the processor 1 and the memory 2.

The PCI control unit 17 controls input and output via PCI Express between the processor 1 and the host processor 3.

The processing unit 10 includes a floating-point multiply-and-add unit 11, part of a vector register 12, an operation instruction control unit 13, and an operation instruction buffer 14. In each processing unit 10, a plurality of sets of the floating-point multiply-and-add units 11 and the parts of the vector registers 12 are included.

The operation instruction buffer 14 buffers an operation instruction input from the memory controller 16.

Under control from the overall instruction control unit 15, the operation instruction control unit 13 issues an instruction about control of an operation instruction buffered in the operation instruction buffer 14 to the floating-point multiply-and-add unit 11 and the part of the vector register 12.

The vector value of an operation instruction is input to the part of the vector register 12.

The floating-point multiply-and-add unit 11, which is an example of an arithmetic processing unit, performs floating-point operations and fixed-point operations.

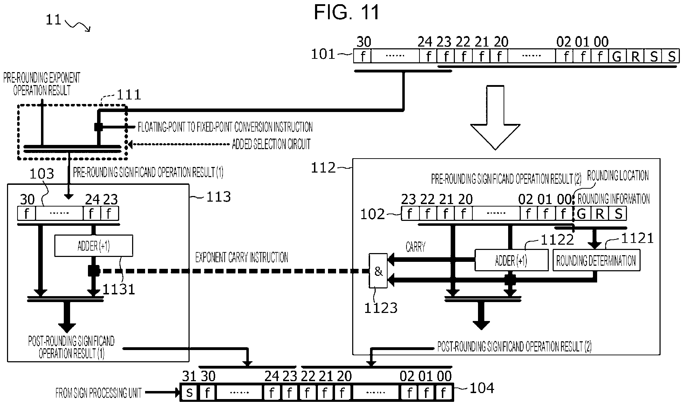

FIG. 11 is a diagram illustrating circuitry that performs rounding during floating-point to fixed-point conversion in the floating-point multiply-and-add unit 11 illustrated in FIG. 10.

The floating-point multiply-and-add unit 11 includes a selection circuit 111, a rounding circuit 112, and a floating-point exponent calculation unit 113.

The selection circuit 111 outputs a specific bit (for example, a higher-order bit) of a fixed-point number when a floating-point to fixed-point conversion instruction (this instruction may be referred to as an instruction signal) is input, and outputs the exponent of a floating-point number when the floating-point to fixed-point conversion instruction is not input.

An adder 1131 of the floating-point exponent calculation unit 113 may be used during execution of a floating-point to fixed-point conversion instruction. Therefore, higher-order bits 30 to 23 of a pre-rounding significand operation result 101, which are to be input to the rounding circuit 112 according to the related example, are coupled in accordance with an instruction from the operation instruction control unit 13 so as to be input instead of the pre-rounding exponent operation result to the floating-point exponent calculation unit 113. This allows the floating-point exponent calculation unit 113 and the rounding circuit 112 to cooperate with each other to perform a rounding operation during floating-point to fixed-point conversion.

For example, if a rounding operation is required in the rounding circuit 112 as a result of a rounding determination 1121, the value of an adder 1122, to which a bits 22 to 0 portion 102 of the rounding circuit 112 has been input, is output. However, if a rounding operation is not required, the bits 22 to 0 portion 102 is output intact as a post-rounding significand operation result.

Additionally, if a rounding operation is required and bits 22 to 0 are all "1", an exponent carry instruction is output to the floating-point exponent calculation unit 113 via an AND operation circuit 1123.

These operations are the same between a floating-point operation and floating-point to fixed-point conversion.

In the floating-point exponent calculation unit 113, during execution of a floating-point to fixed-point conversion instruction, a higher-order bits 30 to 23 portion 103 of a pre-rounding significand operation result is input in accordance with an instruction from the operation instruction control unit 13. Thus, when a rounding operation is required and bits 22 to 0 are all "1", an exponent carry instruction is output from the rounding circuit 112. Further, a result of an adder 1131, to which the higher-order bits 30 to 23 of the significand operation result of the floating-point exponent calculation unit 113 have been input based on the exponent carry instruction, is output as a post-rounding significand operation result.

When a rounding operation is not required or bits 22 to 0 are not all "1", an exponent carry instruction is not output from the rounding circuit 112, and therefore the higher-order bits 30 to 23 portion 103 of the significand operation result is output intact as a post-rounding significand operation result.

When an operation result 104 is output, higher-order bits 30 to 23 of the post-rounding significand operation result may be output to the same location as the exponent in the related example, and therefore the selection circuit 8 between a floating-point exponent operation result and a post-rounding significand operation result in floating-point to fixed-point conversion illustrated in FIG. 9 is unnecessary.

In other words, the floating-point exponent calculation unit 113 is an example of a first arithmetic circuit that performs a predetermined arithmetic operation on a specific bit or the exponent output from the selection circuit 111. The rounding circuit 112 is an example of a second arithmetic circuit that performs a predetermined arithmetic operation on a bit other than the specific bit of the fixed-point number or the significand of a floating-point number and, based on rounding information included in the bit other than the specific bit or the significand, performs rounding on the bit other than the specific bit or the significand.

The rounding circuit 112 issues a carry instruction to the floating-point exponent calculation unit 113 when a carry is generated in a bit other than the specific bit or the significand by the predetermined arithmetic operation on the bit other than the specific bit or the significand. In response to receiving a carry instruction from the rounding circuit 112, the floating-point exponent calculation unit 113 performs a carry process on the specific bit or the exponent.

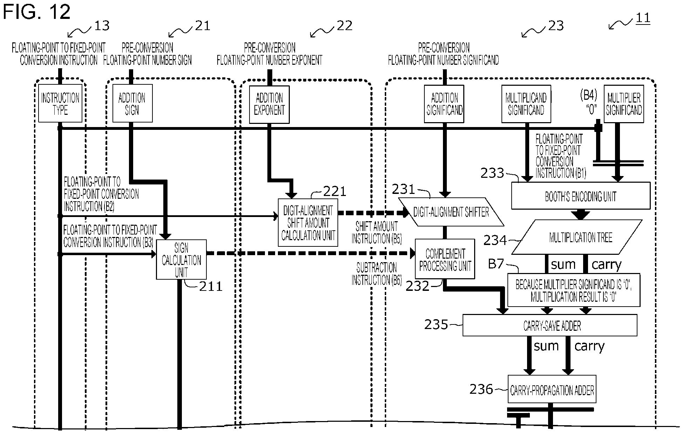

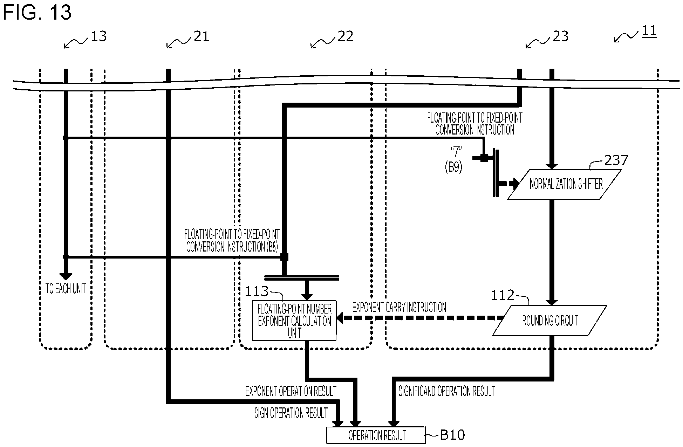

FIG. 12 and FIG. 13 are block diagrams illustrating a configuration of the floating-point multiply-and-add unit 11 illustrated in FIG. 10.

As illustrated in FIG. 12 and FIG. 13, the floating-point multiply-and-add unit 11 functions as a sign processing unit 21, an exponent processing unit 22, and a significand processing unit 23. The sign processing unit 21, the exponent processing unit 22, and the significand processing unit 23 operate under control from the operation instruction control unit 13.

The sign processing unit 21 includes a sign calculation unit 211 as illustrated in FIG. 12.

The exponent processing unit 22 includes a digit-alignment shift amount calculation unit 221 as illustrated in FIG. 12 and includes the floating-point exponent calculation unit 113 as illustrated in FIG. 13.

The significand processing unit 23 includes a digit-alignment shifter 231, a complement processing unit 232, a Booth's encoding unit 233, a multiplication tree 234, a carry-save adder 235, and a carry-propagation adder 236 as illustrated in FIG. 12 and includes a normalization shifter 237 and the rounding circuit 112 as illustrated in FIG. 13.

With reference to FIG. 3 in the related example, the operation of shifting for achieving alignment with the decimal point location of an output, which is denoted by reference character A1, and the complement process in the case of a negative sign, which is denoted by reference character A2, may be implemented by using addition functions included in the floating-point multiply-and-add unit 11.

For example, for the shifting operation denoted by reference character A1 in FIG. 3, in the case of adding the significand of a multiplication result and the significand to be added, since the decimal point locations of both are different, the digit-alignment shifter 231 that performs digit alignment is used.

For the complement process denoted by reference character A2 in FIG. 3, when an actual operation is a subtraction process because of the relationship between the sign of a multiplication result and the sign of a significand to be added, the complement processing unit 232 is used for performing an addition after performing a complement process of the significand to be added.

With reference to FIG. 12 and FIG. 13, a process of conversion to a fixed-point number in the floating-point multiply-and-add unit 11 will be described below.

As illustrated in FIG. 12, the operation instruction control unit 13 receives a floating-point to fixed-point conversion instruction and instructs the sign processing unit 21, the exponent processing unit 22, and the significand processing unit 23 to execute the floating-point to fixed-point conversion instruction (see reference characters B1 to B3). The operation instruction control unit 13 also provides to the significand processing unit 23 an input indicating that the multiplier significand is "0" (see reference character B4).

Upon receiving a floating-point to fixed-point conversion instruction, the digit-alignment shift amount calculation unit 221 of the exponent processing unit 22 references the exponent of a floating-point number to be converted. The digit-alignment shift amount calculation unit 221 shifts the significand of the floating-point number including an implicit bit "1" so that the most significant bit of the final addition result (namely, an output of the carry-propagation adder 236) is located at bit 30 of a fixed-point number to be output. For this purpose, the digit-alignment shift amount calculation unit 221 inputs a shift amount instruction (namely, an output location adjustment amount instruction) to the digit-alignment shifter 231 of the significand processing unit 23 (see reference character B5).

The digit-alignment shifter 231 of the significand processing unit 23 performs a shift to achieve digit alignment based on the shift amount instruction from the exponent processing unit 22.

Upon receiving a floating-point to fixed-point conversion instruction, the sign calculation unit 211 of the sign processing unit 21 inputs a subtraction instruction (namely, a complement conversion instruction) to the complement processing unit 232 of the significand processing unit 23 if the sign of a floating-point number to be converted is negative (see reference character B6).

The complement processing unit 232 of the significand processing unit 23 performs a complement process based on the subtraction instruction from the sign processing unit 21.

The Booth's encoding unit 233 of the significand processing unit 23 performs encoding according to the Booth's multiplication algorithm based on a multiplicand significand and a multiplier significand.

The multiplication tree 234 of the significand processing unit 23 outputs a sum signal and a carry signal.

In the significand processing unit 23, because the multiplier significand is set to "0", the significand of a multiplication result is "0" (see reference character B7).

The carry-save adder 235 of the significand processing unit 23 outputs a sum signal and a carry signal.

The carry-propagation adder 236 of the significand processing unit 23 sequentially sends carry information for the next bit calculation based on the sum signal and the carry signal from the carry-save adder.

Since the significand of the multiplication result is "0" in the multiplication tree 234, the value from the digit-alignment shifter 231 and the complement processing unit 232 is output as is, and the value of the final multiply-add operation is bit 30 and the lower-order bits of a fixed-point number that is output after a floating-point number to be converted is converted.

As illustrated in FIG. 13, in the case of a floating-point to fixed-point conversion instruction, according to a floating-point to fixed-point conversion instruction from the operation instruction control unit 13 (see reference character B8), 8 bits from the most significant bit of an output from the carry-propagation adder 236, which are an operation result, are input to the floating-point exponent calculation unit 113 of the exponent processing unit 22. The 8 bits from the most significant bit of an output from the carry-propagation adder 236 correspond to bits 30 to 23 of a fixed-point number to be output.

An operation result is input to the normalization shifter 237 of the significand processing unit 23 and, in the case of a floating-point to fixed-point conversion instruction, the shift amount is fixed to "7" because of an input from the operation instruction control unit 13 (see reference character B9). As a result, the operation result is shifted left by 7 bits in the normalization shifter 237, and therefore bit 23 and the lower-order bits of a fixed-point number and rounding information are input to the rounding circuit 112.

With a sign operation result from the sign processing unit 21, an exponent operation result from the exponent processing unit 22, and a significand operation result from the significand processing unit 23, a fixed-point number after conversion is output as an operation result (see reference character B10).

[B-2] Example of Operations

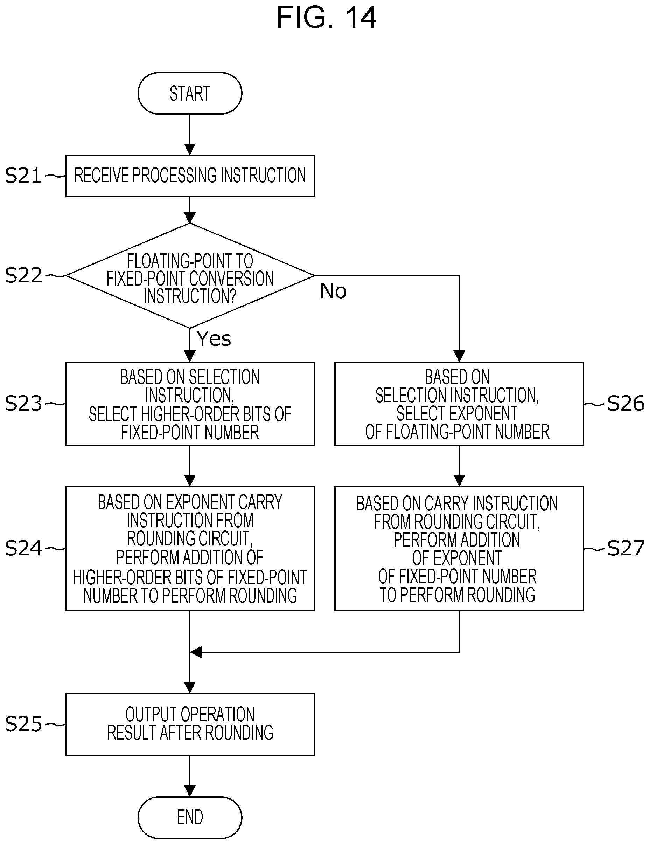

The floating-point exponent calculation process in the floating-point multiply-and-add unit illustrated in FIG. 10 will be described with reference to a flowchart (steps S21 to S27) illustrated in FIG. 14.

The operation instruction control unit 13 receives a processing instruction (step S21).

The exponent processing unit 22 determines whether the received processing instruction is a floating-point to fixed-point conversion instruction (step S22).

If the processing instruction is a floating-point to fixed-point conversion instruction (refer to the Yes route in step S22), the exponent processing unit 22 selects higher-order bits of a fixed-point number based on a selection instruction from the operation instruction control unit 13 (step S23).

Based on an exponent carry instruction from the rounding circuit 112, the exponent processing unit 22 performs an addition process of higher-order bits of the fixed-point number at the floating-point exponent calculation unit 113 to perform rounding (step S24).

The exponent processing unit 22 outputs an operation result after rounding (step S25). The floating-point exponent calculation process then ends.

If, in step S22, the processing instruction is not a floating-point to fixed-point conversion instruction (refer to the No route in step S22), the exponent processing unit 22 selects the exponent of a floating-point number based on a selection instruction from the operation instruction control unit 13 (step S26).

Based on an exponent carry instruction from the rounding circuit 112, the exponent processing unit 22 performs an addition process of the exponent of the floating-point number at the floating-point exponent calculation unit 113 to perform rounding (step S27). The process then proceeds to step S25.

[B-3] Effects

According to the floating-point multiply-and-add unit 11 in the example of the above-described embodiment, for example, the following effects may be obtained and are described with reference to FIG. 11.

The selection circuit 111 outputs a specific bit of a fixed-point number when a floating-point to fixed-point conversion instruction is input, and outputs the exponent of a floating-point number when a floating-point to fixed-point conversion instruction is not input. The floating-point exponent calculation unit 113 performs a predetermined arithmetic operation on the specific bit or the exponent output from the selection circuit 111.

Thus, an arithmetic operation on the specific bit (for example, a higher-order bit) of a fixed-point number may be performed by the floating-point exponent calculation unit 113, which is provided for an arithmetic operation on the exponent of a floating-point number. Accordingly, arithmetic operations of a fixed-point number and a floating-point number may be performed with fewer circuit components.

The rounding circuit 112 performs a predetermined arithmetic operation on a bit other than the specific bit in the fixed-point number or the significand of a floating-point number and, based on rounding information included in the bit other than the specific bit or the significand, performs rounding on the bit other than the specific bit or the significand.

This ensures that rounding processes during arithmetic operations of a floating-point number and a fixed-point number may be performed.

The rounding circuit 112 issues a carry instruction to the floating-point exponent calculation unit 113 when a carry is generated in a bit other than the specific bit or the significand by the predetermined arithmetic operation on the bit other than the specific bit or the significand. In response to receiving a carry instruction from the rounding circuit 112, the floating-point exponent calculation unit 113 performs a carry process on the specific bit or the exponent.

This ensures that carry processes during operations of a floating-point number and a fixed-point number may be performed.

[C] Others

The disclosed technology is not limited to the aforementioned embodiment but may be carried out with various modifications without departing from the spirit and scope of the present embodiment. Each configuration and each process of the present embodiment may be selected as desired or may be combined as appropriate.

**Claims**

1. An arithmetic processing apparatus comprising:

   a selection circuit that outputs a specific bit of a fixed-point number when an instruction signal for converting a floating-point number to a fixed-point number is input, and outputs an exponent of the floating-point number when the instruction signal is not input; and
   a first arithmetic circuit that performs a predetermined arithmetic operation on the specific bit or the exponent output from the selection circuit.

2. The arithmetic processing apparatus according to claim 1, further comprising:
   a second arithmetic circuit that performs a predetermined arithmetic operation on a bit other than the specific bit of the fixed-point number or a significand of the floating-point number and, based on rounding information included in the bit other than the specific bit or the significand, performs rounding on the bit other than the specific bit or the significand.

3. The arithmetic processing apparatus according to claim 2,
   wherein the second arithmetic circuit, when a carry is generated in the bit other than the specific bit or the significand by the predetermined arithmetic operation on the bit other than the specific bit or the significand, issues a carry instruction to the first arithmetic circuit, and
   wherein, in response to receiving the carry instruction from the second arithmetic circuit, the first arithmetic circuit performs a carry process on the specific bit or the exponent.

4. A control method of an arithmetic processing apparatus, the control method comprising:

   outputting, from a selection circuit, a specific bit of a fixed-point number when an instruction signal for converting a floating-point number to a fixed-point number is input, and outputting, from the selection circuit, an exponent of the floating-point number when the instruction signal is not input; and

performing a first predetermined arithmetic operation on the specific bit or the exponent output from the selection circuit.

5. The control method according to claim 4, the control method further comprising:
performing a second predetermined arithmetic operation on a bit other than the specific bit of the fixed-point number or a significand of the floating-point number and, based on rounding information included in the bit other than the specific bit or the significand, performing rounding on the bit other than the specific bit or the significand.

6. The control method according to claim 5, the control method further comprising:

issuing, when a carry is generated in the bit other than the specific bit or the significand by the second predetermined arithmetic operation on the bit other than the specific bit or the significand, a carry instruction, and
performing, in response to the carry instruction, a carry process on the specific bit or the exponent.

FIG. 1

| 31 | 30 | | | | 23 | 22 | | | | | | | | | 0 |
|---|---|---|---|---|---|---|---|---|---|---|---|---|---|---|---|

| SIGN | EXPONENT (8 bit) | SIGNIFICAND (23 bit) |
|---|---|---|

FIG. 2

## FIG. 3

SIGNIFICAND OF INPUT FLOATING-POINT NUMBER

SHIFT SIGNIFICAND IN ACCORDANCE WITH VALUE OF
EXPONENT SO AS TO ACHIEVE ALIGNMENT WITH
DECIMAL POINT LOCATION TO BE OUTPUT (A1)

FOR EXPONENT = 127
(EXPONENT EXCEPT BIAS = 0)

PLACE OF $2^0$

FOR EXPONENT = 143 (EXPONENT EXCEPT BIAS = 16)

PLACE OF $2^{16}$

FROM SIGN

IF SIGN IS NEGATIVE, 2'S COMPLEMENT NUMBER IS TAKEN (A2)

ROUNDING
LOCATION

ROUNDING (A3)

OUTPUT FIXED-POINT NUMBER

DECIMAL POINT LOCATION

# FIG. 4

ROUNDING LOCATION

| − | − | − | ulp | G | R | S | ······ |

← SIGNIFICANT DIGIT →

OR OF SUBSEQUENT BITS

## FIG. 5

| ulp | G | R | S | ROUNDING OPERATION | REMARKS |
|-----|---|---|---|--------------------|---------|
| 0 | 0 | - | - | none | - |
| 0 | 1 | 0 | 0 | none | ROUND TO NEAREST EVEN NUMBER |
| 0 | 1 | 0 | 1 | ADD +1 TO ulp | - |
| 0 | 1 | 1 | - | ADD +1 TO ulp | - |
| 1 | 0 | - | - | none | - |
| 1 | 1 | 0 | 0 | ADD +1 TO ulp | ROUND TO NEAREST EVEN NUMBER |
| 1 | 1 | 0 | 1 | ADD +1 TO ulp | - |
| 1 | 1 | 1 | - | ADD +1 TO ulp | - |

## FIG. 6

FIG. 7

## FIG. 8

PRE-ROUNDING EXPONENT OPERATION RESULT  ~7

07  ~602  01 00
| e | ...... | e | e |  ~71

ADDER (+1)

EXPONENT CARRY INSTRUCTION

POST-ROUNDING EXPONENT
OPERATION RESULT

6~

PRE-ROUNDING SIGNIFICAND OPERATION RESULT   ROUNDING LOCATION

23 22 21 20        02 01 00  ROUNDING INFORMATION
601~| 1. | f | f | f | ...... | f | f | f | G | R | S |

CARRY                              ~61                ~62
&                          ADDER (+1)      ROUNDING DETERMINATION

~63

POST-ROUNDING SIGNIFICAND OPERATION RESULT

31 30            24 23 22 21 20        02 01 00
FROM SIGN PROCESSING UNIT →| s | e | ...... | e | e | f | f | f | ...... | f | f | f |

603

FIG. 9

NOT USED DURING EXECUTION OF FLOATING-POINT
TO FIXED-POINT CONVERSION INSTRUCTION

— 7

702

07          01 00

| e | ...... | e | e | 71

ADDER (+1)

FLOATING-POINT NUMBER EXPONENT
OPERATION RESULT

6 —

701          PRE-ROUNDING SIGNIFICAND OPERATION RESULT          ROUNDING LOCATION

30          24 23 22 21 20          02 01 00: ROUNDING INFORMATION

| f | ...... | f | f | f | f | f | ...... | f | f | f | G | R | S |

64 —          CARRY          — 61          — 62

ADDED ADDER ------▶ ADDER (+1)          ADDER (+1)          ROUNDING DETERMINATION

POST-ROUNDING SIGNIFICAND
OPERATION RESULT

8

SELECTION CIRCUIT TO BE ADDED ------▶

FLOATING-POINT TO FIXED-POINT
CONVERSION INSTRUCTION

31 30          24 23 22 21 20          02 01 00

FROM SIGN PROCESSING UNIT ——▶ | s | f | ...... | f | f | f | f | f | ...... | f | f | f |

703

18

FIG. 10

# FIG. 11

FIG. 12

FIG. 13

~13   ~21   ~22   ~23   ~11

FLOATING-POINT TO FIXED-POINT
CONVERSION INSTRUCTION

"7"
(B9)

NORMALIZATION SHIFTER ~237

FLOATING-POINT TO FIXED-POINT
CONVERSION INSTRUCTION (B8)

TO EACH UNIT

113~

FLOATING-POINT NUMBER
EXPONENT CALCULATION
UNIT

EXPONENT CARRY INSTRUCTION

112~

ROUNDING CIRCUIT

EXPONENT OPERATION RESULT

SIGNIFICAND OPERATION RESULT

SIGN OPERATION RESULT

OPERATION RESULT ~B10

# FIG. 14

START

S21 — RECEIVE PROCESSING INSTRUCTION

S22 — FLOATING-POINT TO FIXED-POINT CONVERSION INSTRUCTION?

No

Yes

S23 — BASED ON SELECTION INSTRUCTION, SELECT HIGHER-ORDER BITS OF FIXED-POINT NUMBER

S26 — BASED ON SELECTION INSTRUCTION, SELECT EXPONENT OF FLOATING-POINT NUMBER

S24 — BASED ON EXPONENT CARRY INSTRUCTION FROM ROUNDING CIRCUIT, PERFORM ADDITION OF HIGHER-ORDER BITS OF FIXED-POINT NUMBER TO PERFORM ROUNDING

S27 — BASED ON CARRY INSTRUCTION FROM ROUNDING CIRCUIT, PERFORM ADDITION OF EXPONENT OF FIXED-POINT NUMBER TO PERFORM ROUNDING

S25 — OUTPUT OPERATION RESULT AFTER ROUNDING

END

Europäisches
Patentamt
European
Patent Office
Office européen
des brevets

**EUROPEAN SEARCH REPORT**

Application Number

EP 19 20 0007

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | EP 1 061 436 A2 (ADVANCED MICRO DEVICES INC [US]) 20 December 2000 (2000-12-20) * column 0116 - column 0121 * * paragraph [0195] - paragraph [0231]; figure 28 * ----- | 1-6 | INV. G06F7/483 G06F9/30 |
| A | US 6 529 928 B1 (RESNICK DAVID R [US] ET AL) 4 March 2003 (2003-03-04) * column 5, line 4 - column 7, line 55 * ----- | 1-6 | |
| A | US 5 917 741 A (NG KENNETH Y [US]) 29 June 1999 (1999-06-29) * column 5, line 41 - column 10, line 5 * ----- | 1-6 | |

TECHNICAL FIELDS
SEARCHED      (IPC)

G06F

The present search report has been drawn up for all claims

| Place of search | Date of completion of the search | Examiner |
|---|---|---|
| Munich | 13 February 2020 | Tenbieg, Christoph |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons

................................................................

& : member of the same patent family, corresponding
document

EPO FORM 1503 03.82 (P04C01)

## ANNEX TO THE EUROPEAN SEARCH REPORT
## ON EUROPEAN PATENT APPLICATION NO.

EP 19 20 0007

This annex lists the patent family members relating to the patent documents cited in the above-mentioned European search report.
The members are as contained in the European Patent Office EDP file on
The European Patent Office is in no way liable for these particulars which are merely given for the purpose of information.

13-02-2020

| Patent document cited in search report | | Publication date | Patent family member(s) | Publication date |
|---|---|---|---|---|
| EP 1061436 | A2 | 20-12-2000 | NONE | |
| US 6529928 | B1 | 04-03-2003 | NONE | |
| US 5917741 | A | 29-06-1999 | NONE | |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 5173759 A

- JP 2009093662 A